Europäisches Patentamt

European Patent Office

Office européen des brevets

(19)

(11) EP 0 735 427 B1

(12)  EUROPEAN PATENT SPECIFICATION

(45) Date of publication and mention
of the grant of the patent:
**16.06.1999 Bulletin 1999/24**

(51) Int Cl.⁶: **G03F 7/07**

(21) Application number: **95200753.2**

(22) Date of filing: **27.03.1995**

(54) **A method for making a lithographic printing plate according to silver salt diffusion transfer process**

Verfahren zur Herstellung einer lithographischen Druckplatte nach dem Silbersalz-Diffusionübertragungsverfahren

Méthode de préparation d'une plaque d'impression lithographique suivant le procédé de diffusion transfert de sel d'argent

(84) Designated Contracting States:
**BE DE FR GB NL**

(43) Date of publication of application:
**02.10.1996 Bulletin 1996/40**

(73) Proprietor: **AGFA-GEVAERT N.V.**
**2640 Mortsel (BE)**

(72) Inventors:
• **Van de Wynckel, Werner**
**B-2640 Mortsel (BE)**
• **Torfs, Piet**
**B-2640 Mortsel (BE)**
• **Vanooteghem, Luc**
**B-2640 Mortsel (BE)**

(56) References cited:
**EP-A- 0 482 479**          **EP-A- 0 628 877**

• **PATENT ABSTRACTS OF JAPAN vol. 14 no. 25 (P-991) ,18 January 1990 & JP-A-01 266543 (FUJI PHOTO FILM) 24 October 1989,**

## Description

### 1. Field of the invention.

The present invention relates to a method for making a lithographic printing plate according to silver salt diffusion transfer processing. In particular, the present invention relates to an improvement of such method involving the use of a processor for processing an image-wise exposed imaging element to a lithographic printing plate.

### 2. Background of the invention.

The principles of the silver complex diffusion transfer reversal process, hereinafter called DTR-process, have been described e.g. in US-P-2352014 and the book "Photographic Silver Halide Diffusion Processes" by André Rott and Edith Weyde - The Focal Press -London and New York, (1972).

According to the DTR process, a silver complex salt is image-wise transferred by diffusion from the image-wise exposed silver halide emulsion layer into the image receiving layer, where it is converted to a silver image usually in the presence of physical development nuclei. For this purpose, the image-wise exposed silver halide emulsion layer is developed in the presence of a developing agent and non-developed silver halide is converted by means of a silver halide complexing agent into a soluble silver complex salt while in contact with an image receiving layer.

A DTR-image bearing material can be used as a planographic printing plate wherein the DTR-silver image areas form the water-repellant ink-receptive areas on a water-receptive ink-repellant surface. The DTR-image can be formed in the image-receiving layer of a sheet or web material which is a separate element with respect to the photographic silver halide emulsion material (a so-called two-sheet DTR element) disclosed in e.g. DE-A-2.346.378 or in the image-receiving layer of a so-called single-support-element, also called mono-sheet element, which contains at least one photographic silver halide emulsion layer integral with an image-receiving layer in water permeable relationship therewith. It is the latter mono-sheet version which is preferred for the preparation of offset printing plates by the DTR method.

In order to prepare a lithographic printing plate from a monosheet DTR imaging element, the imaging element is developed in an alkaline processing liquid subsequent to an image-wise exposure. Such alkaline processing liquid generally comprises as active compounds, an inorganic alkali, a hydrophobizing agent, an inorganic sulphite and a silver halide solvent. Optionally, the alkaline processing liquid also comprises a developing agent.

Generally, a thus developed imaging element is stabilised using a stabilising liquid that generally reduces the high pH at the surface of the imaging element. For this purpose, the stabilising liquid will conveniently have a pH between 4 and 7. The stabilising liquid may further include a hydrophobizing agent.

According to a preferred practice, the making of a printing plate is automated using a plate processor that automatically processes an image-wise exposed imaging element. Such processor at least includes a developing unit and preferably also a stabilising unit. An image-wise exposed imaging element is guided and transported through the different units by means of guide rollers and guide plates.

However, it has been found that such automatic processing sometimes results in printing plates exhibiting poor print performances such as bad ink acceptance in particular areas and/or a reduced printing endurance with regard to an expected print endurance. This problem is particularly apparent in case the imaging element is exposed by means of a high intensity short time scanning exposure such as a laser beam exposure, L.E.D. exposure or CRT exposure.

### 3. Summary of invention

Accordingly, it is an object of the present invention to provide a method for making a lithographic printing plate according to silver salt diffusion transfer processing, involving the use of an automatic processor and wherein the aforementioned problems are resolved.

Further objects of the present invention will become clear from the description hereinafter.

According to the present invention the objects of the present invention are accomplished by the method as set out in the claims.

### 4. Brief description of the drawings:

The present invention will be described in more detail making reference to the following drawings, however without the intention to limit the invention thereto.

Figure 1 represents a schematic drawing of a processor in accordance with a preferred embodiment of the present invention.

Figure 2 represents a side view of an automatic plate maker comprising an exposure unit 30, a bridge 35 and a processor 40.

### 5. Detailed description of the invention

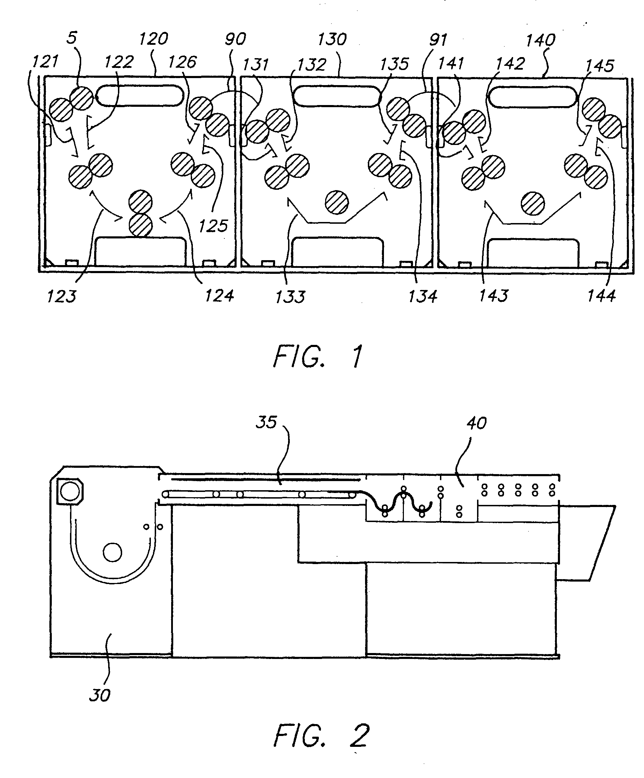

Figure 1 shows a schematic drawing of a processor in accordance with a particularly preferred embodiment of the present invention. The processor according to figure 1 includes a developing unit 120, a stabilising unit 130 and a rinsing unit 140. Each of these units including a plurality of guide rollers such as entrance guide rollers 5 and guide plates 121 to 126, 131 to 135 and 141 to 145 respectively. One or more of the guide rollers are driven by a motor so as to transport an image-wise exposed imaging element through the processor. Guide plates 121 to 126 are used to guide the imaging element through the developing unit whereas guide plates 131 to 135 and 141 to 145 are used to guide the imaging element respectively through the stabilising unit and rinsing unit. Guidance of the imaging element from the developing unit to the stabilising unit is accomplished by a curved plate 90 and a similar curved plate 91 is used for guidance between the stabilising unit and rinsing unit.

In accordance with the present invention, it has been found that automatic processing of an imaging element to a lithographic printing plate with a good printing performance can be accomplished when the surface roughness $R_a$ of the guide plates 121 to 126 (developing unit), 131 to 135 (stabilising unit) and 141 to 145 (rinsing unit) is not more than 0.3μm at the side making contact with the imaging element during transportation through the relevant unit.

In accordance with the present invention, $R_a$ is obtained in accordance with the following formula:

$$R_a = (1/m) \cdot \int_0^m |f(x)| \, dx \quad (\mu m)$$

with m being 0.8mm

Preferably, guide plates 121 to 126, 131 to 135 and 141 to 145 are made of stainless steel which has been electrolitically polished. However, one or more of the guide plates may be of a different material such as e.g. nickel plated stainless steel, plastic coated steel such as e.g. steel coated with polyethylene, polypropylene and the like, as long as the surface roughness $R_a$ is not more than 0.3μm.

According to a particularly preferred embodiment of the present invention (shown in figure 2), a processor 40 in accordance with the present invention is linked via a light-tight bridge 35 to an exposure unit 30 for image-wise exposing an imaging element. Such exposure unit may be a conventional camera or an image-setter including a high intensity short time scanning exposure unit such as e.g. a laser.

An imaging element for use in accordance with the method of the present invention comprises on a support in the order given a silver halide emulsion layer and a layer comprising physical development nuclei.

The silver halide emulsions can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V. L. Zelikman et al in "Making and Coating Photographic Emulsion", The Focal Press, London (1966).

The photographic silver halide emulsions used according to the present invention can be prepared by mixing the halide and silver solutions in partially or fully controlled conditions of temperature, concentrations, sequence of addition, and rates of addition. The silver halide can be precipitated according to the single-jet method or the double-jet method.

The silver halide particles of the photographic emulsions used according to the present invention may have a regular crystalline form such as a cubic or octahedral form or they may have a transition form. They may also have an irregular crystalline form such as a spherical form or a tabular form, or may otherwise have a composite crystal form comprising a mixture of said regular and irregular crystalline forms.

According to the present invention the emulsion or emulsions preferably consist principally of silver chloride while a fraction of silver bromide is present ranging from 1 mole % to 40 mole %. The emulsions preferably belong to the core/shell type well known to those skilled in the art in the sense that substantially all the bromide is concentrated in the core. This core contains preferably 10 to 40 % of the total silver halide precipitated, while the shell consists preferably of 60 to 90 % of the total silver halide precipitated.

The average size of the silver halide grains may range from 0.10 to 0.70 μm , preferably from 0.25 to 0.45 μm.

The size distribution of the silver halide particles of the photographic emulsions to be used according to the present invention can be homodisperse or heterodisperse. A homodisperse size distribution is obtained when 95% of the grains have a size that does not deviate more than 30% from the average grain size.

Preferably during the precipitation stage Iridium and/or Rhodium containing compounds or a mixture of both are added. The concentration of these added compounds ranges from $10^{-8}$ to $10^{-3}$ mole per mole of $AgNO_3$, preferably between $10^{-7}$ and $10^{-6}$ mole per mole of $AgNO_3$. This results in the building in in the silver halide crystal lattice of minor amounts of Iridium and/or Rhodium, so-called Iridium and/or Rhodium dopants. As known to those skilled in the art numerous scientific and patent publications disclose the addition of Iridium or Rhodium containing compounds or compounds containing other elements of Group VIII of the Periodic System during emulsion preparation.

The emulsions can be chemically sensitized e. g. by adding sulphur-containing compounds during the chemical ripening stage e.g. allyl isothiocyanate, allyl thiourea, and sodium thiosulphate. Also reducing agents e.g. the tin compounds described in BE-P 493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem.

46, 65-72 (1951).

The emulsions of the DTR element can be spectrally sensitized according to the spectral emission of the exposure source for which the DTR element is designed.

Suitable sensitizing dyes for the visible spectral region include methine dyes such as those described by F.M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, homopolar cyanine dyes, hemicyanine dyes, styryl dyes and hemioxonol dyes. Particularly valuable dyes are those belonging to the cyanine dyes, merocyanine dyes, complex merocyanine dyes.

More details about the composition, preparation and coating of silver halide emulsions can be found in e.g. Product Licensing Index, Vol. 92, December 1971, publication 9232, p 107-109.

The layer containing physical development nuclei is preferably free of hydrophilic binder but may comprise small amounts upto 30% by weight of the total weight of said layer of a hydrophilic colloid e.g. polyvinyl alcohol to improve the hydrophilicity of the surface. Preferred development nuclei for use in accordance with the present invention are sulphides of heavy metals e. g. sulphides of antimony, bismuth, cadmium, cobalt, lead, nickel, palladium, platinum, silver, and zinc. Especially suitable development nuclei in connection with the present invention are palladium sulphide nuclei. Other suitable development nuclei are heavy metal salts such as e.g. selenides, polyselenides, polysulphides, mercaptans, and tin (II) halides. Heavy metals, preferably silver, gold, platinum, palladium, and mercury can be used in colloidal form.

Between the support and the silver halide emulsion layer there is preferably provided a base layer that preferably contains an anti-halation substance such as e.g. light-absorbing dyes absorbing the light used for image-wise exposure of the imaging element. As alternative finely divided carbon black can be used as an anti-halation substance. On the other hand, in order to gain sensitivity, light reflecting pigments, e.g. titaniumdioxide can be present in the base layer. Further this layer can contain hardening agents, matting agents, e.g. silica particles, and wetting agents. Suitable matting agents preferably have an average diameter of 2-10μm and more preferably between 2μm and 5μm. The matting agents are generally used in a total amount in the imaging element of 0.1g/m$^2$ to 2.5g/m$^2$. At least part of these matting agents and/or light reflection pigments may also be present in the silver halide emulsion layer the most part, preferably at least 80% by weight however preferably being present in said base-layer. As a further alternative the light reflecting pigments may be present in a separate layer provided between the antihalation layer and the photosensitive silver halide emulsion layer.

In a preferred embodiment in connection with the present invention a backing layer is provided at the non-light sensitive side of the support. This layer which can serve as anti-curl layer can contain i.a. matting agents e.g. silica particles, lubricants, antistatic agents, light absorbing dyes, opacifying agents, e.g. titanium oxide and the usual ingredients like hardeners and wetting agents. The backing layer can consist of one single layer or a multiple layer pack e.g. a double layer pack.

Suitable supports for an imaging element in accordance with the present invention are e.g. opaque or transparent polyester supports, e.g. polyethyleneterephthalate film supports, paper supports e.g. polyethylene coated paper etc..

An alkaline processing liquid used for developing the imaging element in accordance with the method of the present invention preferably contains at least part of the silver halide solvent(s). Preferably the silver halide solvent is used in an amount between 0.01% by weight and 10% by weight and more preferably between 0.05% by weight and 8% by weight. Suitable silver halide solvents for use in connection with the present invention are e.g. 2-mercaptobenzoic acid, cyclic imides, oxazolidones, thiocyanates and thiosulfates. Further suitable silver halide solvents for use in connection with the present invention are described in EP-A-554584.

According to the present invention an alkaline processing liquid preferably also contains hydrophobizing agents for improving the hydrophobicity of the silver image obtained in the image receiving surface layer. The hydrophobizing agents used in connection with the present invention are compounds that are capable of reacting with silver or silver ions and that are hydrophobic i.e. insoluble in water or only slightly soluble in water. Generally these compounds contain a mercapto group or thiolate group and one or more hydrophobic substituents e.g. an alkyl group containing at least 3 carbon atoms. Examples of hydrophobizing agents for use in accordance with the present invention are e.g. those described in US-P 3,776,728, US-P 4,563,410 and EP-A-554584.

The alkaline processing liquid may also contain the developing agent(s) used in accordance with the present invention. In this case the alkaline processing liquid is called a developer. On the other hand some or all of the developing agent(s) may be present in one or more layers of the imaging element. When all of the developing agents are contained in the imaging element the alkaline processing liquid is called an activator or activating liquid.

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidinone-type developing agent and/or p-monomethylaminophenol. Particularly useful auxiliary developing agents are of the phenidone type e.g. 1-phenyl-3-pyrazolidinone, 1-phenyl-4-monomethyl-3-pyrazolidinone, and 1-phenyl-4,4-dimethyl-3-pyrazolidinone. However other developing agents can be used.

The alkaline processing liquid preferably also contains a preserving agent having antioxidation activity, e.g. sulphite ions provided e.g. by sodium or potassium sulphite. For example, the aqueous alkaline solution comprises sodium sulphite in an amount ranging from 0.15 to 1.0 mol/l. Further may be present a thickening agent, e.g. hydroxyethylcellulose and carboxymethylcellulose, fog inhibiting agents, e.g. potassium bromide, potassium iodide and a benzotriazole which is known to improve the printing endurance, calcium-sequestering compounds, anti-sludge agents, and hardeners including latent hardeners.

Development acceleration can be accomplished with the aid of various compounds to the alkaline processing liquid and/or one or more layers of the photographic element, preferably polyalkylene derivatives having a molecular weight of at least 400 such as those described in e.g. US-P 3,038,805 - 4,038,075 - 4,292,400 - 4,975,354.

Subsequent to the development in an alkaline processing liquid the pH of the surface of the printing plate is preferably reduced using a stabilising liquid.

A stabilising liquid generally has a pH between 5 and 7. The stabilising liquid preferably contains a buffer e.g. a phosphate buffer, a citrate buffer or mixture thereof. A stabilising solution can further contain bactericides, e.g. phenol, thymol or 5-bromo-5-nitro-1,3-dioxan as described in EP 0,150,517. The liquid can also contain substances which influence the hydrophobic / hydrophilic balance of the printing plate obtained after processing of the DTR element, e.g. silica. Further the stabilising solution can contain wetting agents, preferably compounds containing perfluorinated alkyl groups.

Subsequent to stabilisation as set out above, the printing plate may be rinsed in a rinsing unit of a processor in connection with the present invention. A rinsing liquid that may be conveniently used for this purpose is plain water.

EXAMPLE

Commercially available imaging elements (Supermaster™ available from Agfa-Gevaert NV, Belgium) comprising on a support in the order given an anti-halation layer, a silver halide emulsion layer and a physical development nuclei layer were image-wise exposed using a camera exposure.

Thus obtained image-wise exposed imaging elements were then processed in a processor according to figure 1 wherein the developing unit contained as an alkaline processing liquid G260, the stabilising unit contained as a stabilising liquid G360 (all commercially available from Agfa-Gevaert NV) and the rinsing unit contained plain water as a rinsing liquid.

The processing of imaging elements was varied by using various guidance plates 121 to 126, 131 to 135 and 141 to 145 having different surface roughness values $R_a$ as listed in the table below.

Each of the thus obtained printing plates was then used to print on a printing press using a commonly employed ink and a dampening liquid containing colloidal silica. The printing performance of each of the plates was evaluated by quantifying the failure of an adequate ink acceptance on certain areas of the printing plate. A number on a scale of 1 to 5 was given wherein 1 indicates a very poor ink acceptance and 5 indicates a reliable good ink acceptance. The results are listed in the table below.

| Surface roughness $R_a$ ($\mu$m) | ink acceptance |
|---|---|
| 0.2 | 5 |
| 0.4 | 3 |
| 0.6 | 1 |

**Claims**

1. A method for making a lithographic printing plate according to silver salt diffusion transfer processing, said method comprising the steps of:

   - image-wise exposing an imaging element comprising on a support in the order given a silver halide emulsion layer and a layer comprising physical development nuclei;
   - processing a thus obtained image-wise exposed imaging element using a processor comprising a developing unit, said developing unit comprising (i) a tank holding an alkaline processing liquid, (ii) a plurality of guide rollers 5 and guide plates 121 to 126 for transporting and guiding said image-wise exposed imaging element through said alkaline processing liquid characterised in that said guide plates 121 to 126 exhibit a surface roughness $R_a$ of 0.3$\mu$m or less at the side of said guide plates 121 to 126 making contact with said image-wise exposed imaging element during transportation of said image-wise exposed imaging element through said developing unit.

2. A method according to claim 1 wherein said image-wise exposure is a high-intensity short time scanning exposure.

3. A method according to claim 1 wherein said processor further includes a stabilising unit comprising a tank holding a stabilising liquid, a plurality of guide rollers 5 and guide plates 131 to 135, said guide plates 131 to 135 exhibiting a surface roughness $R_a$ of 0.3$\mu$m or less at the side of said guide plates 131 to 135 making contact with said image-wise exposed imaging element during transportation of said image-wise exposed imaging element through said stabilising unit.

4. A method according to claim 3 wherein said processor further includes a rinsing unit comprising a tank holding a rinsing liquid, a plurality of guide rollers 5 and guide plates 141 to 145, said guide plates 141 to 145 exhibiting a surface roughness $R_a$ of 0.3μm or less at the side of said guide plates 141 to 145 making contact with said image-wise exposed imaging element during transportation of said image-wise exposed imaging element through said rinsing unit.

**Patentansprüche**

1. Ein Verfahren zur Herstellung einer lithografischen Druckplatte nach dem Silbersalz-Diffusionsübertragungsverfahren, das die folgenden Stufen umfaßt :

   - die bildmäßige Belichtung eines bilderzeugenden Elements, das auf einem Träger der angegebenen Reihe nach eine Silberhalogenid-Emulsionsschicht und eine physikalische Entwicklungskeime enthaltende Schicht enthält, und
   - die Verarbeitung eines so erhaltenen bildmäßig belichteten bilderzeugenden Elements in einem Entwicklungsgerät mit einer Entwicklungseinheit, die (i) einen Behälter mit einer alkalischen Verarbeitungsflüssigkeit und (ii) eine Vielzahl von Führungswalzen 5 und Führungsplatten 121 bis 126, die das bildmäßig belichtete bilderzeugende Element durch die alkalische Verarbeitungsflüssigkeit führen und befördern, umfaßt, dadurch gekennzeichnet, daß die Führungsplatten 121 bis 126 an ihrer Seite, die während der Beförderung des bildmäßig belichteten bilderzeugenden Elements durch die Entwicklungseinheit mit dem bildmäßig belichteten bilderzeugenden Element in Kontakt kommt, eine Oberflächenrauheit $R_a$ von höchstens 0,3 μm aufweisen.

2. Verfahren nach Anspruch 1, dadurch gekennzeichnet, daß die bildmäßige Belichtung eine Kurzzeitabtastbelichtung hoher Intensität ist.

3. Verfahren nach Anspruch 1, dadurch gekennzeichnet, daß das Entwicklungsgerät weiterhin eine Stabilisierungseinheit umfaßt, die einen Behälter mit einer Stabilisierungsflüssigkeit und eine Vielzahl von Führungswalzen 5 und Führungsplatten 131 bis 135 umfaßt, wobei die Führungsplatten 131 bis 135 an ihrer Seite, die während der Beförderung des bildmäßig belichteten bilderzeugenden Elements durch die Stabilisierungseinheit mit dem bildmäßig belichteten bilderzeugenden Element in Kontakt kommt, eine Oberflächenrauheit $R_a$ von höchstens 0,3 μm aufweisen.

4. Verfahren nach Anspruch 3, dadurch gekennzeichnet, daß das Entwicklungsgerät weiterhin eine Spüleinheit umfaßt, die einen Behälter mit einer Spülflüssigkeit und eine Vielzahl von Führungswalzen 5 und Führungsplatten 141 bis 145 umfaßt, wobei die Führungsplatten 141 bis 145 an ihrer Seite, die während der Beförderung des bildmäßig belichteten bilderzeugenden Elements durch die Spüleinheit mit dem bildmäßig belichteten bilderzeugenden Element in Kontakt kommt, eine Oberflächenrauheit $R_a$ von höchstens 0,3 μm aufweisen.

**Revendications**

1. Procédé pour fabriquer un cliché d'impression lithographique conformément au procédé de transfert par diffusion de sels d'argent, ledit procédé comprenant les étapes consistant à:

   - exposer en forme d'image un élément de formation d'image comprenant sur un support, dans l'ordre donné, une couche d'émulsion à l'halogénure d'argent et une couche comprenant des germes de développement physique;
   - traiter un élément de formation d'image exposé en forme d'image ainsi obtenu en utilisant une machine à développer comprenant une unité de développement, ladite unité de développement comprenant (i) un réservoir contenant un liquide de traitement de type alcalin, (ii) plusieurs cylindres de guidage 5 et plusieurs plaques de guidage 121 à 126 pour transporter et guider ledit élément de formation d'image exposé en forme d'image à travers ledit liquide de traitement de type alcalin, caractérisé en ce que lesdites plaques de guidage 121 à 126 manifestent une rugosité de surface ($R_a$) de 0,3 μm ou moins sur le côté desdites plaques de guidage 121 à 126 entrant en contact avec ledit élément de formation d'image exposé en forme d'image au cours du transport dudit élément de formation d'image exposé en forme d'image à travers ladite unité de développement.

2. Procédé selon la revendication 1, dans lequel ladite exposition en forme d'image est une exposition réalisée par balayage pendant un bref laps de temps et avec une intensité élevée.

3. Procédé selon la revendication 1, dans lequel ladite machine à développer comprend en outre une unité de stabilisation comprenant un réservoir contenant un liquide de stabilisation, plusieurs cylindres de guidage 5 et plusieurs plaques de guidage 131 à 135, lesdites plaques de guidage 131 à 135 manifestant une rugosité de surface ($R_a$) de 0,3 µm ou moins sur le côté desdites plaques de guidage 131 à 135 entrant en contact avec ledit élément de formation d'image exposé en forme d'image au cours du transport dudit élément de formation d'image exposé en forme d'image à travers ladite unité de stabilisation.

4. Procédé selon la revendication 3, dans lequel ladite machine à développer englobe en outre une unité de rinçage comprenant un réservoir contenant un liquide de rinçage, plusieurs cylindres de guidage 5 et plusieurs plaques de guidage 141 à 145, lesdites plaques de guidage 141 à 145 manifestant une rugosité de surface ($R_a$) de 0,3 µm ou moins sur le côté desdites plaques de guidage 141 à 145 entrant en contact avec ledit élément de formation d'image exposé en forme d'image au cours du transport dudit élément de formation d'image exposé en forme d'image à travers ladite unité de rinçage.

FIG. 1

FIG. 2